# EUROPEAN PATENT APPLICATION

(11) **EP 4 832 682 A1**
(43) Date of publication of application: **28.10.2026**
(21) Application number: 25849637.1
(22) Date of filing: 03.06.2025
(51) Int. Cl.: H05K 7/20

(54) **LIQUID COOLING SYSTEM FOR COOLING SERVO CABINET**

(30) Priority: 25.02.2025 US 202563762672 P
(71) Applicant: Delta Electronics Inc., Taoyuan City 320023 (TW)
(72) Inventor: WANG, Cih-ping, Taoyuan City 320023 (TW); LIANG, Jen Te, Taoyuan City 320023 (TW); WU, Sheng-chi, Taoyuan City 320023 (TW); CHUNG, Li An, Taoyuan City 320023 (TW); TSAI, Chih-hung, Taoyuan City 320023 (TW)
(74) Representative: 2K Patent Partnerschaft mbB
(86) International application number: PCT/CN2025/098731
(87) International publication number: WO 2026/178999

(57) **Abstract**

A liquid cooling system includes a liquid supply outlet, a liquid recovery outlet, a cooling unit, a water storage tank, and a controller. The liquid supply outlet and the liquid recovery inlet are connected to a server cabinet. The cooling unit receives a coolant after a temperature of the server cabinet is increased through the liquid recovery inlet, and operate a plurality of fans to cool the coolant. The controller detects a flow rate of the coolant and records a pressure difference between the liquid supply outlet and the liquid recovery inlet as a second setpoint when the flow rate reaches a first setpoint. Under the liquid cooling system operating in a flow rate control mode, the controller switches to a pressure difference control mode when the flow rate is determined to be abnormal, and control the pump to operate according to the second setpoint.

## Description

### Technical Field

The present disclosure relates to a server cabinet, and more particularly to a liquid cooling system for cooling a server cabinet.

### Description of Related Art

A liquid cooling system is a system that dissipates heat from multiple servers in a server cabinet by delivering a coolant to the server cabinet. Specifically, the liquid cooling system delivers low-temperature coolant into the server cabinet to absorb the heat energy generated by multiple servers in the server cabinet, and recovers the high-temperature coolant after absorbing the heat. Furthermore, after the liquid cooling system cools the high-temperature coolant and turns the coolant back into the low-temperature coolant, it circulates the low-temperature coolant into the server cabinet.

In general, the method of controlling the liquid cooling system includes a flow rate control and a pressure difference control. The flow rate control is to keep the total flow rate of coolant input (supplied) into the server cabinet fixed, while the pressure difference control is to keep the pressure difference of coolant between the input terminal (i.e., one terminal where low-temperature coolant is input into the server cabinet) and the output terminal (i.e., one terminal where high-temperature coolant is received from the server cabinet) fixed. However, whether using the flow rate control or pressure difference control, the system will not be able to perform effective control when the flow sensor or differential pressure gauge fails.

Some liquid cooling systems will directly input coolant to the servo machine based on a preset flow rate after a sensor failure. Some liquid cooling systems will immediately switch to another control mode after a sensor failure, such as using a flow rate control mode originally and switching to a pressure difference control mode immediately after the flow sensor fails. However, the pipelines and filters of the liquid cooling system may precipitate or become clogged after a period of use, and the server cabinet may also cause impedance changes due to the replacement of internal servers. These reasons will cause a large difference between the preset flow rate and the current actual flow rate, which will cause drastic fluctuations in the pump after the control mode is switched.

On the other hand, if the flow rate control is switched to the pressure difference control immediately, the flow setpoint and the pressure difference setpoint may not match, which may also cause drastic fluctuations in the operation of the pump, thereby causing adverse effects on the server cabinet. Similarly, when the pressure difference control is switched to the flow rate control immediately, there will also be the problem of the pressure difference setpoint and the flow setpoint not matching.

### SUMMARY

The present disclosure provides a liquid cooling system for cooling a server cabinet, which can switch the liquid cooling system from a flow rate control mode to a pressure difference control mode, or from the pressure difference control mode to the flow rate control mode without causing drastic fluctuations in the pump.

In one embodiment, the liquid cooling system of the present disclosure includes a liquid supply outlet, a liquid recovery inlet, a cooling unit, a water storage tank, and a controller. The liquid supply outlet is connected to a liquid inlet of the server cabinet. The liquid recovery inlet is connected to a liquid outlet of the server cabinet. The cooling unit includes a plurality of fans, wherein the cooling unit receives a coolant after a temperature of the server cabinet is increased through the liquid recovery inlet, and operates the plurality of fans to cool the coolant. The water storage tank includes at least one pump, wherein the water storage tank operates the at least one pump to input the cooled coolant from the liquid supply outlet to the server cabinet. The controller detects a flow rate of the coolant at the liquid recovery inlet or the liquid supply outlet, and records a pressure difference between the liquid supply outlet and the liquid recovery inlet as a second setpoint when the flow rate reaches a first setpoint. Under the liquid cooling system operating in a flow rate control mode, the controller switches to a pressure difference control mode when the at least one pump is in operation and the flow rate of the liquid recovery inlet or the liquid supply outlet is determined to be abnormal, and controls the at least one pump to operate according to the second setpoint.

In one embodiment, the liquid cooling system of the present disclosure includes a liquid supply outlet, a liquid recovery inlet, a cooling unit, a water storage tank, and a controller. The liquid supply outlet is connected to a liquid inlet of the server cabinet. The liquid recovery inlet is connected to a liquid outlet of the server cabinet. The cooling unit includes a plurality of fans, wherein the cooling unit receives a coolant after a temperature of the server cabinet is increased through the liquid recovery inlet, and operates the plurality of fans to cool the coolant. The water storage tank includes at least one pump, wherein the water storage tank operates the at least one pump to input the cooled coolant from the liquid supply outlet to the server cabinet. The controller to detects a pressure difference of the coolant at the liquid recovery inlet or the liquid supply outlet, and records a flow rate between the liquid supply outlet and the liquid recovery inlet as a second setpoint when the pressure difference reaches a first setpoint. Under the liquid cooling system operating in a pressure difference control mode, the controller switches to a flow rate control mode when the at least one pump is in operation and the pressure difference is determined to be abnormal, and controls the at least one pump to operate according to the second setpoint.

Compared to the related art, the liquid cooling system of the present disclosure can avoid drastic fluctuations in the system after switching the currently used control mode, thereby maintaining the stability of the system control, and will not affect the delivery of coolant due to sensor failure, and will not damage the server cabinet connected to the liquid cooling system.

### BRIEF DESCRIPTION OF DRAWINGS

FIG. 1 is a schematic diagram of a liquid cooling system according to a first embodiment of the present disclosure.
FIG. 2 is a block diagram of the liquid cooling system according to an embodiment of the present disclosure.
FIG. 3 is a flowchart of a method for controlling the liquid cooling system according to a first embodiment of the present disclosure.
FIG. 4 is a flowchart of a method for controlling the liquid cooling system according to a second embodiment of the present disclosure.
FIG. 5 is a schematic diagram of the liquid cooling system according to a second embodiment of the present disclosure.

### Component symbols for the attached diagram:

1: Liquid Cooling System
10: Controller
11: Liquid Supply Outlet
12: Liquid Recovery Inlet
13: Cooling Unit
131: Fan
14: Water Storage Tank
141: Pump
15: Memory
151: First Setpoint
152: Second Setpoint
16: Flow Meter
17: Differential Pressure Gauge
2: Coolant
3: Server Cabinet
31: Liquid Inlet
32: Liquid Outlet
4: Server
S31~S37: Control Steps
S41~S47: Control Steps

### DETAILED DESCRIPTION

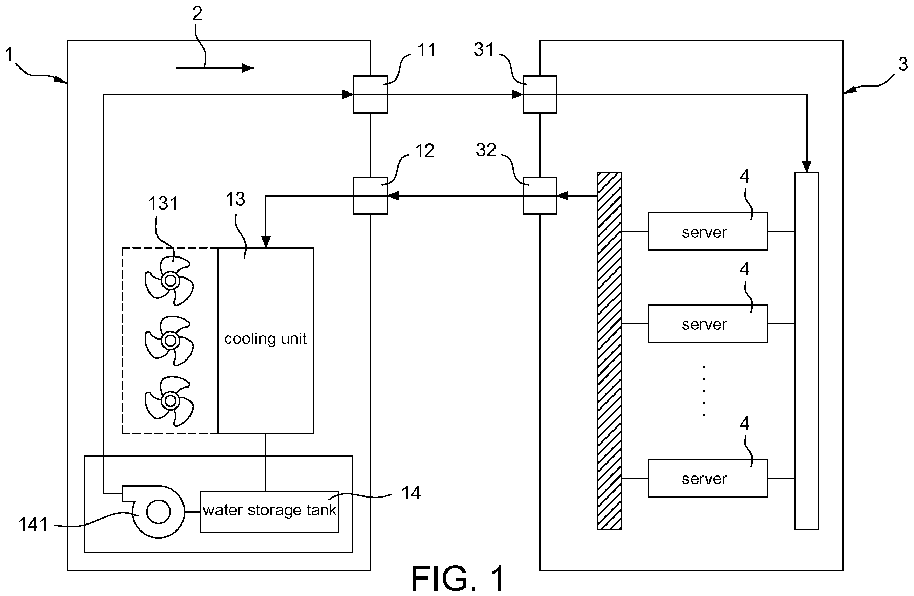

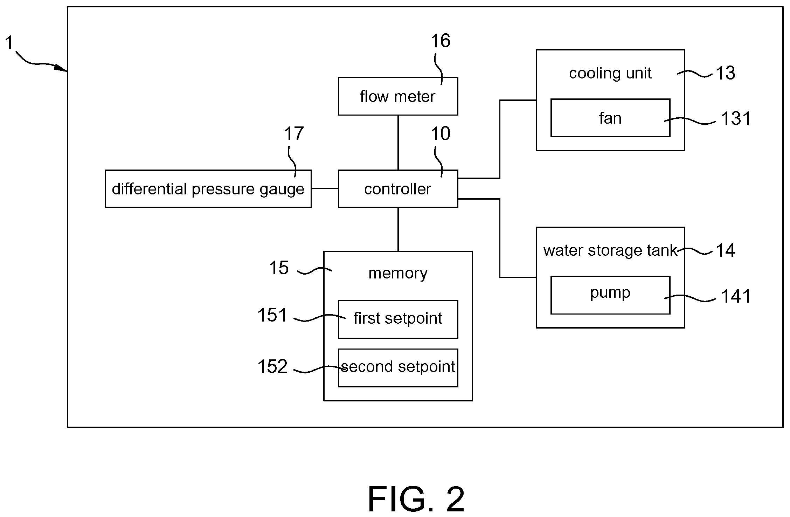

Please refer to FIG. 1 and FIG. 2, which respectively show a schematic diagram of a liquid cooling system according to a first embodiment of the present disclosure and a block diagram of the liquid cooling system according to an embodiment of the present disclosure. The present disclosure provides a liquid cooling system 1 for cooling a server cabinet 3. As shown in FIG. 1, the liquid cooling system 1 includes a liquid supply outlet 11 and a liquid recovery inlet 12. The server cabinet 3 includes a liquid inlet 31 and a liquid outlet 32. The liquid cooling system 1 is connected to the liquid inlet 31 of the server cabinet 3 through the liquid supply outlet 11, and is connected to the liquid outlet 32 of the server cabinet 3 through the liquid recovery inlet 12.

The liquid cooling system 1 has a coolant 2. The coolant 2 may be, for example but not limited to, water, ethylene glycol aqueous solution, propylene glycol aqueous solution, refrigeration oil, or refrigerant, and so on. The liquid cooling system 1 inputs the coolant 2 into the server cabinet 3 through the liquid supply outlet 11, and receives the coolant 2 from the server cabinet 3 through the liquid recovery inlet 12. In particular, the liquid cooling system 1 internally cools the coolant 2 to generate a low-temperature coolant (i.e., cooled coolant), and delivers the low-temperature coolant to the server cabinet 3 to dissipate heat (cool) for multiple servers 4 accommodated in the server cabinet 3. Specifically, after the coolant 2 flows into the server cabinet 3, the coolant 2 absorbs the heat energy generated by the multiple servers 4 and gradually turns into a high-temperature coolant (for example, 25°C to 40°C). When the coolant 2 absorbs heat and turns into the high-temperature coolant (for example, the temperature is equal to or higher than a temperature of the server 4), it no longer has a heat dissipation function.

The liquid cooling system 1 receives high-temperature coolant from the server cabinet 3 through the liquid recovery inlet 12, and cools the high-temperature coolant by internal operation so that the high-temperature coolant is converted into low-temperature coolant (e.g., 15°C to 25°C, i.e., the temperature is lower than the temperature of the server 4) capable of dissipating heat.

As shown in FIG. 1 and FIG. 2, the liquid cooling system 1 has at least one cooling unit 13, and the cooling unit 13 includes a plurality of fans 131. In the present disclosure, after the liquid cooling system 1 receives the coolant 2 (i.e., the high-temperature coolant) from the server cabinet 3, the coolant 2 is guided to the cooling unit 13. The cooling unit 13 operates the plurality of fans 131, and receives the coolant 2 with the temperature increased from the server cabinet 3 through the liquid recovery inlet 12, and then cools the coolant 2 by the operation of the plurality of fans 131 so as to convert the high-temperature coolant into the low-temperature coolant.

In the above-mentioned embodiment, the cooling unit 13 cools the coolant 2 by the plurality of fans 131. In other embodiments, the cooling unit 13 may also be configured with a heat exchanger, a cooling tower, or a chiller to cool the coolant 2, and is not limited to the above-mentioned fan 131.

As shown in FIG. 1 and FIG. 2, the liquid cooling system 1 also has at least one water storage tank 14, and the water storage tank 14 includes at least one pump 141. In the present disclosure, the water storage tank 14 is used to store the cooled coolant 2. Furthermore, the water storage tank 14 is controlled by the controller 10 to operate at least one pump 141 to deliver the coolant 2 (i.e., the low-temperature coolant) to the liquid supply outlet 11 through a pipeline, and to input the low-temperature coolant into the server cabinet 3 through the liquid supply outlet 11. By the cooling process of the cooling unit 13 and the delivery process of the water storage tank 14, the coolant 2 can continuously circulate between the liquid cooling system 1 and the server cabinet 3 to continuously dissipate heat for the multiple servers 4 in the server cabinet 3.

As shown in FIG. 2, the liquid cooling system 1 further includes a controller 10, which is electrically connected to the cooling unit 13 and the water storage tank 14 to control the cooling unit 13, the plurality of fans 131, the water storage tank 14, and the pump 141. In one embodiment, the controller 10 may be implemented by a central processing unit (CPU), a micro control unit (MCU), a programmable logic controller (PLC), a system on chip (SoC), or a field programmable gate array (FPGA).

In the present disclosure, the controller 10 can control the liquid cooling system 1 to operate in a flow rate control mode or a pressure difference control mode. In the flow rate control mode, when the liquid cooling system 1 outputs the coolant 2 to the server cabinet 3, the coolant 2 is maintained at a desired flow rate, such as 100 lpm, 130 lpm, or 150 lpm, and so on, depending on the size of the server cabinet 3, the type and number of multiple servers 4, and other heat dissipation factors. In the pressure difference control mode, when the liquid cooling system 1 inputs the coolant 2 into the server cabinet 3, the pressure difference between the coolant 2 at the output terminal and the coolant 2 at the input terminal is maintained fixed. Therefore, the liquid cooling system 1 can ensure that the coolant 2 input (supplied) to the server cabinet 3 remains stable.

When the controller 10 controls the liquid cooling system 1 to operate in the flow rate control mode, the controller 10 continuously detects the flow rate of the coolant 2. In one embodiment, the controller 10 detects the flow rate of the coolant 2 at the liquid recovery inlet 12. In another embodiment, the controller 10 detects the flow rate of the coolant 2 at the s liquid supply outlet 11. In another embodiment, the controller 10 detects the flow rate of the coolant 2 at any point of the pipeline inside the liquid cooling system 1. The technical feature of the present disclosure is that when the flow rate of the coolant 2 is detected to reach a preset first setpoint 151, the controller 10 obtains a pressure difference between the coolant 2 at the output terminal (e.g., the liquid supply outlet 11) and the coolant 2 at the input terminal (e.g., the liquid recovery inlet 12), and records the pressure difference as a second setpoint 152.

When the flow rate of the coolant 2 is within the first setpoint 151, it means that the operation of the liquid cooling system 1 is normal in the flow rate control mode. Therefore, the pressure difference is a reference value that allows the liquid cooling system 1 to operate normally under similar conditions in the pressure difference control mode. That is, if the controller 10 controls the liquid cooling system 1 to operate in the pressure difference control mode based on the second setpoint 152 at this time, the liquid cooling system 1 can operate under the same or similar operation conditions as in the current flow rate control mode (for example, a speed of the pump 141 is the same or similar).

In the present disclosure, the controller 10 detects the flow rate of the coolant 2 based on a preset frequency. When it is to detect that the current flow rate reaches the first setpoint 151, the pressure difference is detected and the second setpoint 152 is recorded/updated. When the liquid cooling system 1 operates normally (for example, the pump 141 is in operation) and the flow rate at the liquid recovery inlet 12 or the liquid supply outlet 11 is determined to be abnormal, the controller 10 switches the current control mode from the flow rate control mode to the pressure difference control mode, and controls at least one pump 141 to operate according to the last second setpoint 152. The above-mentioned preset frequency may be, for example, every 100ms, every 1s or every 5s, and so on, and is not intended to limit the present disclosure.

As mentioned above, the controller 10 of the present disclosure will continue to update the second setpoint 152 (i.e., the pressure difference in this embodiment) when the liquid cooling system 1 operates normally and the flow rate is normal, that is, the second setpoint 152 will be updated with the status of the liquid cooling system 1 and/or the server cabinet 3. In other words, the second setpoint 152 compensates for the actual status of the liquid cooling system 1 by continuous updating, and therefore will be synchronized with the flow rate to a certain extent. When the controller 10 switches from the flow rate control mode to the pressure difference control mode instantly due to the abnormal flow rate, although the control of the liquid cooling system 1 based on the flow rate is converted to the control of the liquid cooling system 1 based on the second setpoint 152, since the second setpoint 152 has been compensated, the mode switching will not cause drastic fluctuations in the operation of the pump 141, and will not affect the connected server cabinet 3.

Compared with the above-mentioned embodiment, when the controller 10 controls the liquid cooling system 1 to operate in the pressure difference control mode, the controller 10 will continuously detect the pressure difference between the output terminal and the input terminal of the coolant 2 at the liquid cooling system 1. In one embodiment, the controller 10 detects a first pressure value of the coolant 2 at the liquid supply outlet 11 and a second pressure value of the coolant 2 at the liquid recovery inlet 12, and calculates the pressure difference between the first pressure value and the second pressure value. The technical feature of the present disclosure is that when it is to detect that the pressure difference of the coolant 2 reaches the preset first setpoint 151, the controller 10 obtains the flow rate of the coolant 2 at the liquid supply outlet 11 or the flow rate of the coolant 2 at the liquid recovery inlet 12, and records the flow rate as the second setpoint 152.

When the pressure difference of the coolant 2 is within the first setpoint 151, it means that the operation of the liquid cooling system 1 is normal in the pressure difference control mode. Therefore, the flow rate at this time is a reference value that allows the liquid cooling system 1 to operate normally under similar conditions in the flow rate control mode. That is, if the controller 10 controls the liquid cooling system 1 to operate in the flow rate control mode based on the second setpoint 152 at this time, the liquid cooling system 1 can operate under the same or similar operation conditions as in the current pressure difference control mode (for example, the speed of the pump 141 is the same or similar).

Similar to the above-mentioned embodiment, in the pressure difference control mode, the controller 10 can also detect and calculate the current pressure difference based on a preset frequency. When it is to detect that the current pressure difference reaches the first setpoint 151, the flow rate will be detected and the second setpoint 152 is recorded/updated. When the liquid cooling system 1 operates normally (for example, the pump 141 is in operation) and the pressure difference of the coolant 2 is determined to be abnormal, the controller 10 switches the current control mode from the pressure difference control mode to the flow rate control mode, and controls at least one pump 141 to operate according to the last second setpoint 152.

In this embodiment, the controller 10 of the present disclosure will continue to update the second setpoint 152 (i.e., the flow rate in this embodiment) when the liquid cooling system 1 operates normally and the pressure difference is normal, that is, the second setpoint 152 will be updated with the status of the liquid cooling system 1 and/or the server cabinet 3. In other words, the second setpoint 152 compensates for the actual status of the liquid cooling system 1 by continuously updating, and therefore will be synchronized with the pressure difference to a certain extent. When the controller 10 switches from the pressure difference control mode to the flow rate control mode instantly due to the abnormal pressure difference, it will not cause drastic fluctuations in the operation of the pump 141, and will not affect the connected server cabinet 3.

As shown in FIG. 2, the liquid cooling system 1 of the present disclosure further includes a memory 15, a flow meter 16, and a differential pressure gauge 17. The controller 10 is electrically connected to the memory 15, the flow meter 16, and the differential pressure gauge 17.

In one embodiment, the memory 15 may be implemented by a flash memory, a read-only memory, a hard disk, or any equivalent storage component to record the first setpoint 151 and the second setpoint 152.

In one embodiment, the flow meter 16 may be implemented by an ultrasonic flow meter, an electromagnetic flow meter, a turbine flow meter, a Coriolis mass flow meter, or a positive displacement flow meter to detect the flow rate of the coolant 2 inside the liquid cooling system 1, at the output terminal, or at the input terminal.

In one embodiment, the differential pressure gauge 17 includes at least a first pressure sensor and a second pressure sensor. The differential pressure gauge 17 detects the first pressure value of the coolant 2 at the output terminal through the first pressure sensor and detects the second pressure value of the coolant 2 at the input terminal through the second pressure sensor. Afterward, the controller 10 or the differential pressure gauge 17 calculates a difference between the first pressure value and the second pressure value as the pressure difference.

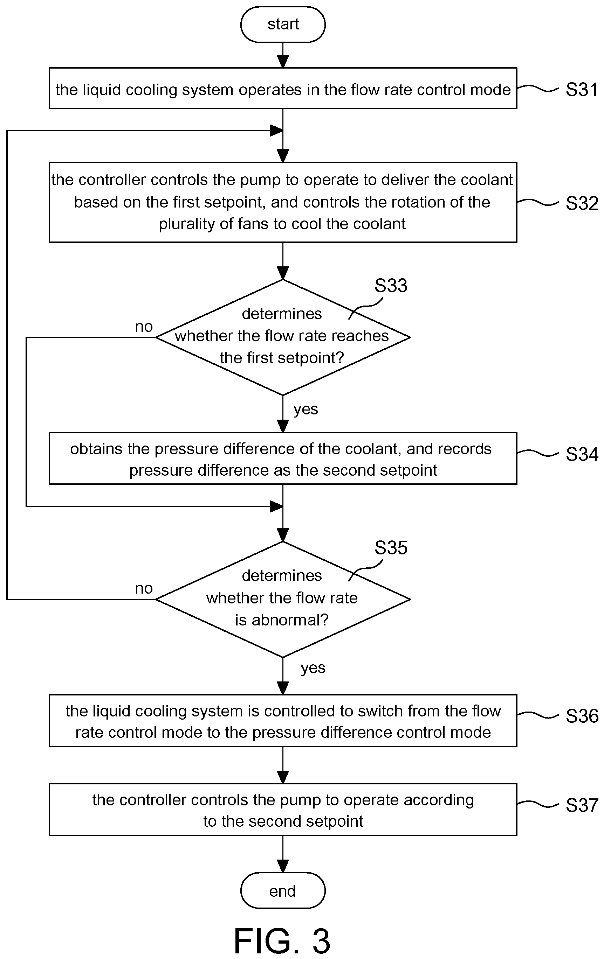

Please refer to FIG. 1 to FIG. 3. FIG. 3 shows a flowchart of a method for controlling the liquid cooling system according to a first embodiment of the present disclosure. FIG. 3 discloses the control procedure of the liquid cooling system 1 of the present disclosure when an abnormality occurs in the flow rate control mode.

In the present disclosure, the first setpoint 151 recorded in the memory 15 of the liquid cooling system 1 corresponds to an initial control parameter of the flow rate control mode. As shown in FIG. 3, after the liquid cooling system 1 is started, the controller 10 controls the liquid cooling system 1 to operate in the flow rate control mode (step S31). Furthermore, the controller 10 controls at least one pump 141 of the water storage tank 14 to operate to deliver the coolant 2 based on the first setpoint 151, and controls the rotation of the plurality of fans 131 of the cooling unit 13 to cool the coolant 2 (step S32). In the present disclosure, the liquid cooling system 1 inputs the cooled coolant 2 into the server cabinet 3 through the liquid supply outlet 11, and receives the coolant 2 with the temperature increased from the server cabinet 3 through the liquid recovery inlet 12.

When the liquid cooling system 1 continuously delivers and recovers the coolant 2, the controller 10 determines whether the flow rate of the coolant 2 reaches the preset first setpoint 151 (step S33). Furthermore, when the controller 10 determines that the flow rate of the coolant 2 reaches the first setpoint 151, the controller 10 obtains the pressure difference between the coolant 2 at the liquid supply outlet 11 and the coolant 2 at the liquid recovery inlet 12, and records pressure difference as the second setpoint 152 (step S34).

In one embodiment, the controller 10 sets an error range of the first setpoint 151. The error range may include a positive error value and a negative error value. For example, the first setpoint 151 is 130 lpm (liter per minute), the positive error value is +5 lpm, and the negative error value is -5 lpm. In this embodiment, the controller 10 determines that the flow rate reaches the first setpoint 151 when the flow rate of the coolant 2 is within the error range of the first setpoint 151 (i.e., 125 lpm to 135 lpm).

In the present disclosure, the controller 10 obtains the flow rate according to a preset measurement frequency, and obtains the current pressure difference (e.g., 100 kPa) of the coolant 2 when the flow rate is determined to be within the error range of the first setpoint 151, and updates the second setpoint 152. If the controller 10 determines that the flow rate exceeds the error range of the first setpoint 151, the controller 10 may not obtain the pressure difference, or obtain the pressure difference but not update the second setpoint 152. More specifically, when the flow rate detected by the flow meter 16 exceeds the error range of the first setpoint 151, it only indicates that the liquid cooling system 1 is not stable enough at present, but the flow meter 16 is not faulty, and the flow rate may return to normal after a period of time. Therefore, when the flow rate exceeds the error range of the first setpoint 151, the controller 10 only suspends the update of the second setpoint 152, but does not switch the control mode immediately.

Afterward, the controller 10 determines whether the flow rate of the coolant 2 is abnormal according to the preset frequency (step S35). If the flow rate is normal, the controller 10 returns to step S32 to continue to deliver the coolant 2, continue to measure the flow rate, and continue to update the second setpoint 152. In one embodiment, the controller 10 determines that the flow meter 16 is faulty and causes the flow rate to be abnormal when the pump 141 operates normally but the flow rate is abnormal (for example, the obtained flow rate is zero, or the flow rate exceeds the normal detection range of the flow meter 16).

If the flow rate is determined to be abnormal in step S35, the controller 10 immediately controls the liquid cooling system 1 to switch from the flow rate control mode to the pressure difference control mode (step S36), and in the pressure difference control mode, controls the pump 141 to operate according to the second setpoint 152 that is last updated (step S37). Therefore, the controller 10 can switch the control mode of the liquid cooling system 1 without causing drastic fluctuations in the liquid cooling system 1 so as to solve the problem that the coolant 2 may not be stably delivered if the flow meter 16 continues to operate in the flow rate control mode due to malfunction or failure.

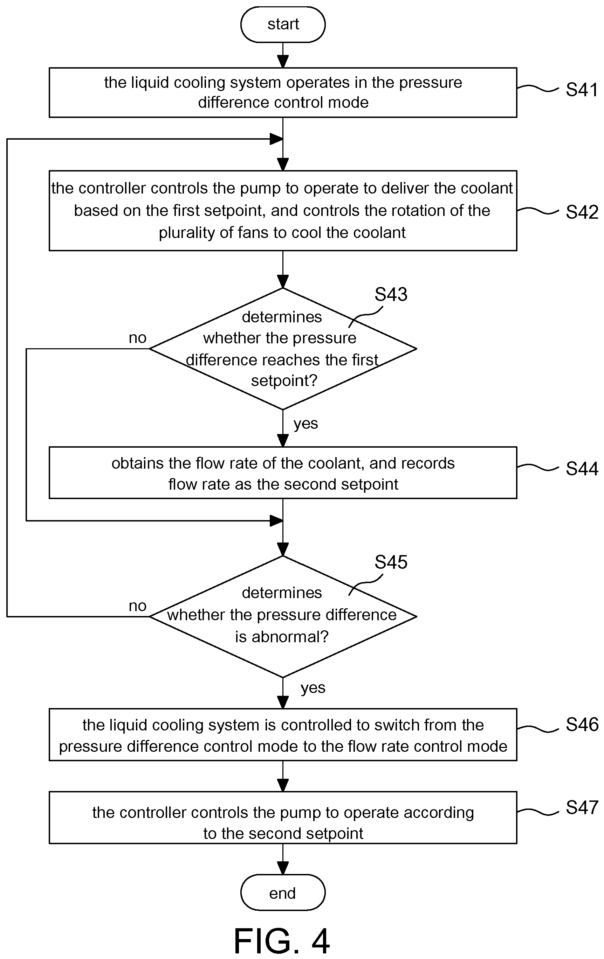

Please refer to FIG. 1, FIG. 2, and FIG. 4. FIG. 4 shows a flowchart of a method for controlling the liquid cooling system according to a second embodiment of the present disclosure. FIG. 4 discloses the control procedure of the liquid cooling system 1 of the present disclosure when an abnormality occurs in the pressure difference control mode.

In the second embodiment of FIG. 4, the first setpoint 151 recorded in the memory 15 of the liquid cooling system 1 corresponds to an initial control parameter of the pressure difference control mode. In the second embodiment, the controller 10 controls the liquid cooling system 1 to operate in the pressure difference control mode after the liquid cooling system 1 is started (step S41).

In one embodiment, the user can set the liquid cooling system 1 to operate in the flow rate control mode or the pressure difference control mode through a human-machine interface (not shown) before or after the liquid cooling system 1 is started. In another embodiment, the liquid cooling system 1 can be preset to operate in the flow rate control mode or the pressure difference control mode. In another embodiment, the controller 10 can detect and evaluate the execution environment after the liquid cooling system 1 is started to determine whether the liquid cooling system 1 should operate in the flow rate control mode or the pressure difference control mode.

In the pressure difference control mode, the controller 10 controls at least one pump 141 to operate to deliver the coolant 2 based on the first setpoint 151, and controls the rotation of the plurality of fans 131 to cool the coolant 2 (step S42). When the liquid cooling system 1 delivers and recovers the coolant 2, the controller 10 continuously determines whether the pressure difference of the coolant 2 reaches the preset first setpoint 151 (step S43). Furthermore, when the controller 10 determines that the pressure difference of the coolant 2 reaches the first setpoint 151, the controller 10 obtains the flow rate of the coolant 2 at the liquid supply outlet 11, or the flow rate of the coolant 2 at the liquid recovery inlet 12, and records the flow rate as the second setpoint 152 (step S44).

Similar to the above-mentioned first embodiment, the controller 10 sets an error range of the first setpoint 151 in the pressure difference control mode, and when the pressure difference of the coolant 2 is within the error range of the first setpoint 151 (for example, the first setpoint 151 is 100 kPa, and the error range is ±5 kPa), the controller 10 determines that the pressure difference reaches the first setpoint 151.

Similar to the above-mentioned first embodiment, the controller 10 obtains the pressure difference according to the preset measurement frequency in the pressure difference control mode, and obtains the current flow rate of the coolant 2 when the pressure difference is determined to be within the error range of the first setpoint 151, and update the second setpoint 152. If the controller 10 determines that the pressure difference exceeds the error range of the first setpoint 151, the controller 10 may not obtain the flow rate, or obtain the flow rate but not update the second setpoint 152.

In the second embodiment, the controller 10 also determines whether the pressure difference of the coolant 2 is abnormal according to the preset frequency (step S45). If the pressure difference is normal, the controller 10 returns to step S42 to continue to deliver the coolant 2, continue to measure the pressure difference, and continue to update the second setpoint 152. In one embodiment, the controller 10 determines that the differential pressure gauge 17 is faulty and causes the pressure difference to be abnormal when the pump 141 operates normally but the pressure difference is abnormal (for example, the obtained pressure difference exceeds the normal detection range of the differential pressure gauge 17).

If the pressure difference is determined to be abnormal in step S45, the controller 10 immediately controls the liquid cooling system 1 to switch from the pressure difference control mode to the flow rate control mode (step S46), and in the flow rate control mode, controls the pump 141 to operate according to the second setpoint 152 that is last updated (step S47). Therefore, the controller 10 can switch the control mode of the liquid cooling system 1 without causing drastic fluctuations in the liquid cooling system 1 so as to solve the problem that the coolant 2 may not be stably delivered if the pressure difference gauge 17 continues to operate in the pressure difference control mode due to malfunction or failure.

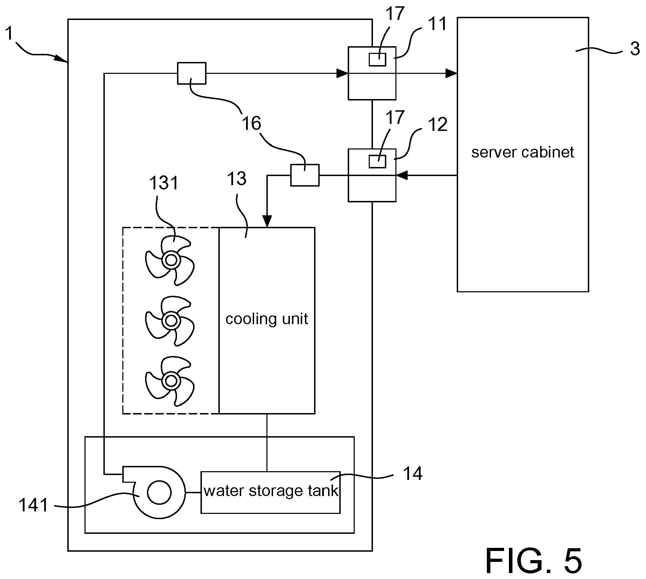

Please refer to FIG. 5, which shows a schematic diagram of the liquid cooling system according to a second embodiment of the present disclosure. In order to detect the flow rate and pressure difference of the coolant 2, the liquid cooling system 1 should be provided with the flow meter 16 and the differential pressure meter 17 on the pipeline. As shown in FIG. 5, in one embodiment, the flow meter 16 may be provided near the liquid supply outlet 11 to detect the flow rate of the coolant 2 at the liquid supply outlet 11. In another embodiment, the flow meter 16 may be provided near the liquid recovery inlet 12 to detect the flow rate of the coolant 2 at the liquid recovery inlet 12.

In another embodiment, the liquid cooling system 1 may be equipped with two flow meters 16, and they are respectively disposed near the liquid supply outlet 11 and near the liquid recovery inlet 12. Therefore, the liquid cooling system 1 can simultaneously detect the flow rate of the coolant 2 at the liquid supply outlet 11 and the flow rate of the coolant 2 at the liquid recovery inlet 12, and the controller 10 can selectively use one of the two flow rates for determination, or calculate the average value of the two flow rates for determination.

In addition, as shown in FIG. 5, the differential pressure gauge 17 of the liquid cooling system 1 may be disposed at the liquid supply outlet 11 and the liquid recovery inlet 12. More specifically, the liquid cooling system 1 may be equipped with a single differential pressure gauge 17, and the two detection terminals of the differential pressure gauge 17 are respectively disposed at the liquid supply outlet 11 and the liquid recovery inlet 12 so as to detect the first pressure value of the coolant 2 at the liquid supply outlet 11 and the second pressure value of the coolant 2 at the liquid recovery inlet 12, and then calculate the pressure difference between the first pressure value and the second pressure value.

In another embodiment, the differential pressure gauge 17 includes two pressure sensors including a first pressure sensor and a second pressure sensor, and the two pressure sensors are disposed at the liquid supply outlet 11 and the liquid recovery inlet 12 respectively. The first pressure sensor detects the first pressure value of the coolant 2 at the liquid supply outlet 11, and the second pressure sensor detects the second pressure value of the coolant 2 at the liquid recovery inlet 12. The controller 10 or the differential pressure gauge 17 calculates the pressure difference between the first pressure value and the second pressure value.

When the liquid cooling system 1 is stably operating in the flow rate control mode or the pressure difference control mode, the present disclosure updates and compensates the initial control parameter of the other control mode according to the current state of the liquid cooling system 1. Therefore, after the control mode is switched, the liquid cooling system 1 will not have too much fluctuation, thereby maintaining the stability of the system to avoid affecting the server cabinet 3 connected to the liquid cooling system 1 due to the sensor failure inside the liquid cooling system 1.

## Claims

1. A liquid cooling system for cooling a server cabinet, comprising
a liquid supply outlet connected to a liquid inlet of the server cabinet,
a liquid recovery inlet connected to a liquid outlet of the server cabinet,
a cooling unit comprising a plurality of fans, wherein the cooling unit is configured to receive a coolant after a temperature of the server cabinet is increased through the liquid recovery inlet, and operate the plurality of fans to cool the coolant,
a water storage tank comprising at least one pump, wherein the water storage tank is configured to operate the at least one pump to input the cooled coolant from the liquid supply outlet to the server cabinet, and
a controller configured to detect a flow rate of the coolant at the liquid recovery inlet or the liquid supply outlet, and record a pressure difference between the liquid supply outlet and the liquid recovery inlet as a second setpoint when the flow rate reaches a first setpoint,
wherein under the liquid cooling system operating in a flow rate control mode, the controller is configured to switch to a pressure difference control mode when the at least one pump is in operation and the flow rate of the liquid recovery inlet or the liquid supply outlet is determined to be abnormal, and control the at least one pump to operate according to the second setpoint.

2. The liquid cooling system as claimed in claim 1, further comprising:
a flow meter disposed near the liquid supply outlet or near the liquid recovery inlet, and configured to detect the flow rate of the coolant.

3. The liquid cooling system as claimed in claim 1, further comprising:
at least one differential pressure gauge disposed at the liquid supply outlet and the liquid recovery inlet, and configured to detect the pressure difference.

4. The liquid cooling system as claimed in claim 1, wherein the controller is configured to determine that the flow rate reaches the first setpoint when the flow rate is within an error range of the first setpoint.

5. The liquid cooling system as claimed in claim 4, wherein the controller is configured to obtain the flow rate according to a measurement frequency; when the flow rate is within the error range of the first setpoint, the current pressure difference is obtained and the second setpoint is updated, and when the flow rate exceeds the error range of the first setpoint, the second setpoint is not updated.

6. The liquid cooling system as claimed in claim 1, wherein the controller is configured to determine that the flow rate is abnormal when the at least one pump normally operates but the flow rate is zero, or the flow rate exceeds a normal detection range of a flow meter.

7. A liquid cooling system for cooling a server cabinet, comprising
a liquid supply outlet connected to a liquid inlet of the server cabinet,
a liquid recovery inlet connected to a liquid outlet of the server cabinet,
a cooling unit comprising a plurality of fans, wherein the cooling unit is configured to receive a coolant after a temperature of the server cabinet is increased through the liquid recovery inlet, and operate the plurality of fans to cool the coolant,
a water storage tank comprising at least one pump, wherein the water storage tank is configured to operate the at least one pump to input the cooled coolant from the liquid supply outlet to the server cabinet, and
a controller configured to detect a pressure difference of the coolant at the liquid recovery inlet or the liquid supply outlet, and record a flow rate between the liquid supply outlet and the liquid recovery inlet as a second setpoint when the pressure difference reaches a first setpoint,
wherein under the liquid cooling system operating in a pressure difference control mode, the controller is configured to switch to a flow rate control mode when the at least one pump is in operation and the pressure difference is determined to be abnormal, and control the at least one pump to operate according to the second setpoint.

8. The liquid cooling system as claimed in claim 7, further comprising:
at least one differential pressure gauge disposed at the liquid supply outlet and the liquid recovery inlet, and configured to detect the pressure difference.

9. The liquid cooling system as claimed in claim 7, further comprising:
a flow meter disposed near the liquid supply outlet or near the liquid recovery inlet, and configured to detect the flow rate of the coolant.

10. The liquid cooling system as claimed in claim 7, wherein the controller is configured to determine that the pressure difference reaches the first setpoint when the pressure difference is within an error range of the first setpoint.

11. The liquid cooling system as claimed in claim 10, wherein the controller is configured to obtain the pressure difference according to a measurement frequency; when the pressure difference is within the error range of the first setpoint, the current flow rate is obtained and the second setpoint is updated, and when the pressure difference exceeds the error range of the first setpoint, the second setpoint is not updated.

12. The liquid cooling system as claimed in claim 7, wherein the controller is configured to determine that the pressure difference is abnormal when the pressure difference exceeds a normal detection range of a differential pressure gauge configured to detect the pressure difference.
